# EUROPÄISCHE PATENTSCHRIFT

(11) **EP 1 516 203 B1**
(45) Veröffentlichungstag und Bekanntmachung des Hinweises auf die Patenterteilung: **26.12.2007**
(21) Anmeldenummer: 03759866.1
(22) Anmeldetag: 18.06.2003
(51) Int. Cl.: G01S 13/50

(54) **VERFAHREN ZUR UNTERDR CKUNG VON ST RUNGEN IN SYSTEMEN Z UR OBJEKTERFASSUNG**
METHOD FOR THE SUPPRESSION OF DISTURBANCES IN SYSTEMS FOR DETECTING OBJECTS
PROCEDE DE SUPPRESSION DE PERTURBATIONS DANS DES SYSTEMES DE DETECTION D'OBJETS

(30) Priorität: 18.06.2002 DE 10250607
(43) Veröffentlichungstag der Anmeldung: 23.03.2005
(73) Patentinhaber: Automotive Distance Control Systems GmbH, 88131 Lindau (DE)
(72) Erfinder: WINTERMANTEL, Markus, 88131 Lindau (DE)
(74) Vertreter: Grau, Ulf
(86) Internationale Anmeldenummer: PCT/DE2003/002046
(87) Internationale Veröffentlichungsnummer: WO 2003/107035

(56) Entgegenhaltungen:
- US-A- 4 672 567
- US-A- 4 717 917
- US-A- 4 723 553
- US-A- 4 963 036
- LEE C L ET AL: "BIT-SLICED MEDIAN FILTER DESIGN BASED ON MAJORITY GATE" IEE PROCEEDINGS G. ELECTRONIC CIRCUITS & SYSTEMS, INSTITUTION OF ELECTRICAL ENGINEERS. STEVENAGE, GB, Bd. 139, Nr. 1, 1. Februar 1992 (1992-02-01), Seiten 63-71, XP000293218 ISSN: 0622-0039

## Beschreibung

Die Erfindung betrifft ein Verfahren zur Unterdrückung von Störungen in Systemen zur Objekterfassung gemäß dem Oberbegriff von Anspruch 1.

Systeme zur Objekterfassung erfassen dabei die Entfernung, die Relativgeschwindigkeit, den relativen Winkel oder die Bildinformation von Objekten im Zielgebiet. Dabei werden Systeme eingesetzt, welche Wellen aussenden und deren Echo auswerten. Dabei kommen Wellen unterschiedlicher physikalischer Natur (z. B. Schallwellen oder elektromagnetische Wellen) und unterschiedlicher Wellenlänge (bei elektromagnetischen Wellen z. B. im Infrarot- oder Radarbereich) zum Einsatz.

Derartige Systeme werden insbesondere zur Regelung des Abstands und der Fahrgeschwindigkeit von Fahrzeugen eingesetzt.

Wird eine Welle mit der Ausbreitungsgeschwindigkeit c an einem Objekt, bspw. einem vorausfahrenden Fahrzeug, in der Entfernung a reflektiert, so empfängt das System nach der Laufzeit Δt = 2a/c die reflektierte und i. allg. gedämpfte Welle e(t). Somit kann aus der Laufzeit Δt auf die Entfernung des Objekts geschlossen werden, solange die Laufzeit Δt immer kleiner als die Pulswiederholzeit T_{PW}(n) ist; im anderen Fall entstehen Mehrdeutigkeitsprobleme - man spricht von Überreichweiten. Bewegt sich das von der Welle erfasste Objekt bzgl. des messenden Systems mit der Relativgeschwindigkeit v, so zeigt die vom System empfangene reflektierte Welle eine Frequenzverschiebung um die Dopplerfrequenz f_{D} = 2fₛv/c. Aus der Dopplerfrequenz f_{D} kann somit auf die Relativgeschwindigkeit v geschlossen werden.

Neben Überreichweiten gibt es in der Praxis gerade bei Kraftfahrzeuganwendungen eine weitere sich gleich auswirkende Störung, nämlich wenn sich mehrere Fahrzeuge mit derartigen Systemen begegnen, so dass Impulse anderer Systeme empfangen werden.

Zur Unterdrückung solcher Störungen eignet sich eine lineare Filterung nicht, da sie zum einen die Störer nur verschleift und zum andern die Spektral- oder Leistungsanalyse ja i. Allg. schon eine lineare Filterung minimaler Bandbreite darstellen.

Aufgabe der Erfindung ist es daher, ein verbessertes Verfahren zur Unterdrückung von solchen Störungen aufzuzeigen. Diese Aufgabe wird durch die Merkmale des Anspruchs 1 gelöst. Vorteilhafte Weiterbildungen sind den Unteransprüchen zu entnehmen.

Um den Einfluss von Überreichweiten sowie von Interferenzen, d. h. gegenseitigen Störungen, von gepulsten, im selben Frequenzbereich arbeitenden Systemen untereinander zu vermindern, wird zunächst eine Pseudo-Noise-Kodierung der Pulswiederholzeit T_{PW}(n) eingesetzt, d. h. die Pulswiederholzeit ist nicht konstant, sondern wird einem Zufallsprozess nach variabel gestaltet. Empfangene Impulse, welche von Überreichweiten oder einem anderen gepulsten System stammen, haben dann zum unmittelbar zuvor ausgesendeten Impuls nicht immer den gleichen, sondern einen stochastisch verteilten Abstand. Aus der US 4,717,917 ist ein solches Verfahren zur Unterdrückung von Störungen bekannt.

Diese Maßnahme allein reicht aber nicht aus, um Überreichweiten und Interferenzen in genügendem Maße zu unterdrücken. Bei Überreichweiten und Interferenzen durch gepulste, im selben Frequenzbereich arbeitende Systeme (mit oder ohne Pseudo-Noise-Kodierung) sind wegen der Pseudo-Noise-Kodierung der Pulswiederholzeit T_{PW}(n) in jedem Entfernungstor i. Allg. nur einzelne Abtastwerte gestört - man spricht von transienten Störern. Aber dies könnte im Falle hoher Störungen schon reichen, dass die weitere Signalverarbeitung (Spektralanalyse zur Dopplerbestimmung z. B. durch FFT oder Leistungsanalyse z. B. durch Leistungsintegration) unbrauchbare Ergebnisse liefert.

Bzgl. dieses Problems wird eine nichtlineare Filterung des digitalisierten Signals (gegebenenfalls nach einer entsprechenden digitalen Vorverarbeitung wie z. B. einer Betragsquadratbildung für eine Leistungsanalyse) vorgeschlagen, welche speziell die transienten Störungen eliminiert. Erst im Zusammenspiel mit dieser Filterung wirkt sich der besondere Vorteil der Pseudo-Noise-Kodierung besonders aus, denn es wird die Störleistung nicht nur stochastisch verteilt, sondern aufgrund der jetzt transienten Störungen wird dieser Anteil wirksam reduziert.

Vorzugsweise wird eine Medianfilterung verwendet, bei der aus jeweils einer ungeraden Anzahl von aufeinanderfolgenden Abtastwerten eines innerhalb eines Entfernungstors erfassten Reflexionssignals der Median bestimmt wird. Die Medianfilterung erweist sich als wirkungsvoll und ist zudem leicht realisierbar. Unter dem Median von einer ungeraden Zahl K an Werten versteht man den mittleren Wert, d. h. den (K+1)/2-kleinsten Wert oder, was identisch ist, den (K+1)/2-größten Wert, was i. Allg. unterschiedlich zum Mittelwert ist. Zum Beispiel ergibt sich für die fünf Werte 5, 3, 2, 79 und 1 der Median 3, als Mittelwert jedoch der Wert 18.

Vorzugsweise wird ein in Relation zur maximalen Nutzfrequenz kurzes Medianfilter verwendet, um die überlagerte Sinusschwingung aus den Abtastwerten ohne signifikante Dämpfung rekonstruieren zu können. Vorzugsweise werden Medianfilter der Länge zwischen 3 bis 9 verwendet. Als besonders vorteilhaft hat sich bei derart kurzen Medianfiltern die Verwendung eines mehrstufigen Medianfilters erwiesen, bei dem die Medianbestimmung wiederholt, also zumindest zweimal hintereinander erfolgt und so eine bessere Filterwirkung bei gleichzeitiger geringer Dämpfung gewährleistet wird. Vorzugsweise wird ein gleitendes Medianfilter mit sich überlappenden Fenstern der Eingangswerte verwendet, d.h. bei gegebener Länge des Filters wird nur eine gegenüber der Länge geringere Anzahl von berücksichtigten alten Eingangswerten durch neue Eingangswerte ersetzt. Insbesondere kann auch ein gleitendes Medianfilter mit der Schrittweite 1 (also ohne Dezimation der Abtastrate) verwendet werden, d.h. es wird gegenüber der vorherigen Medianbildung jeweils nur der älteste Eingangswert durch den aktuellen Eingangswert ersetzt. Dadurch bleibt die Auflösung voll erhalten. Ein zweistufiges Medianfilter mit jeweils der Länge 5 und einer Schrittweite von 1 erweist sich für die betrachteten Anwendungen als bereits äußerst wirkungsvoll. Vorzugsweise erfolgt innerhalb jedes Entfernungstors eine Überabtastung.

Alternativ zur Medianfilterung sind weitere Filter geeignet, die nichtlinear sein müssen, um gerade nur transiente Störungen zu dämpfen.

Die Erfindung wird nachfolgend anhand von Ausführungsbeispielen und Figuren näher erläutert.

Die Figuren zeigen:
- Fig. 1a):: Amplitude bzw. Einhüllende s(t) der ausgesendeten Welle für den Fall von rechteckförmigen Impulsen
- Fig. 1b):: Amplitude bzw. Einhüllende e(t) der empfangenen Welle für den Fall eines Objekts in der Entfernung a, welche in einer Signallaufzeit von Δt = 2a/c resultiert
- Fig. 1c):: gestörtes Empfangssignal e(t), bspw. wegen Überreichweiten oder Interferenzen von einem anderen gepulsten, im selben Frequenzbereich arbeitenden System
- Fig.2a):: Sinusschwingung im diskreten Zeitbereich, welcher zahlreiche hohe Störimpulse überlagert sind; im Spektrum des resultierenden Signals ist der spektrale Peak der Sinusschwingung in dem von den Störimpulsen erzeugten Rauschen verschwunden
- Fig. 2b):: Ausgangssignal nach zweistufiger Medianfilterung mit jeweiliger Filterlänge K = 5, bei dem die Sinusschwingung im Zeitbereich fast vollständig wieder rekonstruiert und im Spektrum somit deutlich sichtbar ist
- Figur 3: Blockschaltbild eines Puls-Doppler-Radarsystems
- Figur 4: vereinfachtes Schaltbild zur Erläuterung des Prinzip des Doppler-Verfahrens;
- Figur 5: die Signal-Zeit-Diagramme für das Schaltbild nach Figur 4;
- Figur 6: die Übertragungsfunktion eines idealen und eines realen Optimalfilters;
- Figur 7: das Schaltbild eines ersten Ausführungsbeispiels eines Optimalfilters;
- Figur 8: das Schaltbild eines zweiten, bevorzugten Ausführungsbeispiels eines Optimalfilters;
- Fig.9a: Algorithmus zur Implementierung eines Median-Filters mit einer bitserielle Abarbeitung für Binärdaten in vorzeichenloser Binärdarstellung
- Fig.9b: Algorithmus zur Implementierung eines Median-Filters mit einer bitserielle Abarbeitung für Binärdaten in Vorzeichen-Betrag-Darstellung
- Fig.9c: Algorithmus zur Implementierung eines Median-Filters mit einer bitserielle Abarbeitung für Binärdaten in Einer- oder Zweier-Komplement-Darstellung
- Fig.10a,b,c: Detail jeweils zu den Fig.9a,9b,9c
- Figur 11: die Übertragungsfunktion eines idealen und eines realen Dezimationstiefpasses;
- Figur 12: die Impulsantwort h(n) eines gleitenden Mittelwertbildners sowie ein Signalflussdiagramm;
- Figur 13: ein vorteilhaften Ausführungsbeispiels eines Dezimationstiefpasses.

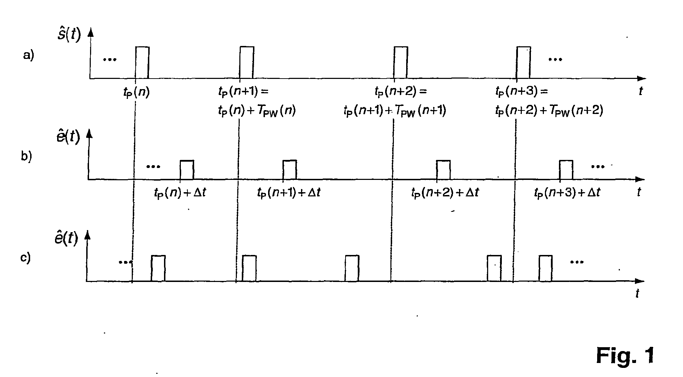

In Fig.1a) ist für eine gepulstes System die Amplitude bzw. Einhüllende s(t) der ausgesendeten Welle der Frequenz fₛ für den Fall von rechteckförmigen Impulsen dargestellt. Die Zeitpunkte, bei denen die Sendeimpulse beginnen, sind im Folgenden mit t_{P}(n) bezeichnet, der Abstand von zwei aufeinanderfolgenden Impulsen ist die Pulswiederholzeit T_{PW}(n).

Wird diese Welle mit der Ausbreitungsgeschwindigkeit c an einem Objekt in der Entfernung a reflektiert, so empfängt das System nach der Laufzeit Δt = 2a/c die reflektierte und i. Allg. gedämpfte Welle e(t); in Fig.1b) ist die Amplitude bzw. Einhüllende e(t) der empfangenen Welle dargestellt. Somit kann aus der Laufzeit Δt auf die Entfernung des Objekts geschlossen werden, solange die Laufzeit Δt immer kleiner als die Pulswiederholzeit T_{PW}(n) ist; im anderen Fall entstehen Mehrdeutigkeitsprobleme - man spricht von Überreichweiten. Bewegt sich das von der Welle erfasste Objekt bzgl. des messenden Systems mit der Relativgeschwindigkeit v, so zeigt die vom. System empfangene reflektierte Welle eine Frequenzverschiebung um die Dopplerfrequenz f_{D} = 2fₛv/c. Somit kann aus der Dopplerfrequenz f_{D} auf die Relativgeschwindigkeit v geschlossen werden.

In Fig.1c) ist die Amplitude bzw. Einhüllende e(t) der empfangenen Welle beispielhaft für Überreichweiten oder Interferenzen von einem anderen gepulsten, im selben Frequenzbereich arbeitenden System dargestellt.

Ausgangspunkt für das verbesserte Verfahren ist eine Pseudo-Noise-Kodierung der Pulswiederholzeit T_{PW}(n), d.h. die Pulswiederholzeit ist nicht konstant, sondern wird einem Zufallsprozess nach variabel gestaltet. Empfangene Impulse, welche von Überreichweiten oder einem anderen gepulsten System stammen, haben dann zum unmittelbar zuvor ausgesendeten Impuls nicht immer den gleichen, sondern einen stochastisch verteilten Abstand.

Das empfangene Signal e(t) wird vorzugsweise nach entsprechender Aufbereitung (z. B. Abmischung auf eine Zwischenfrequenz oder ins Basisband, IQ-Bildung, Filterung) abgetastet. Dabei sind die Abtastzeitpunkte so gewählt, dass sie zur vorhergehenden Sendeimpulszeit t_{P}(n) einen zeitlichen Abstand t_{A}(m), m ∈ {0,1,...,M-1} besitzen; jeder zeitliche Abstand t_{A}(m), m = 0,1,...,M-1, entspricht einem sogenannten Entfernungstor. Für jedes der M Entfernungstore werden pro Zyklus insgesamt N(m) Abtastwerte gebildet; in welcher Weise dies geschieht, ob z. B. seriell oder parallel, ist für die weitere Betrachtung nicht relevant.

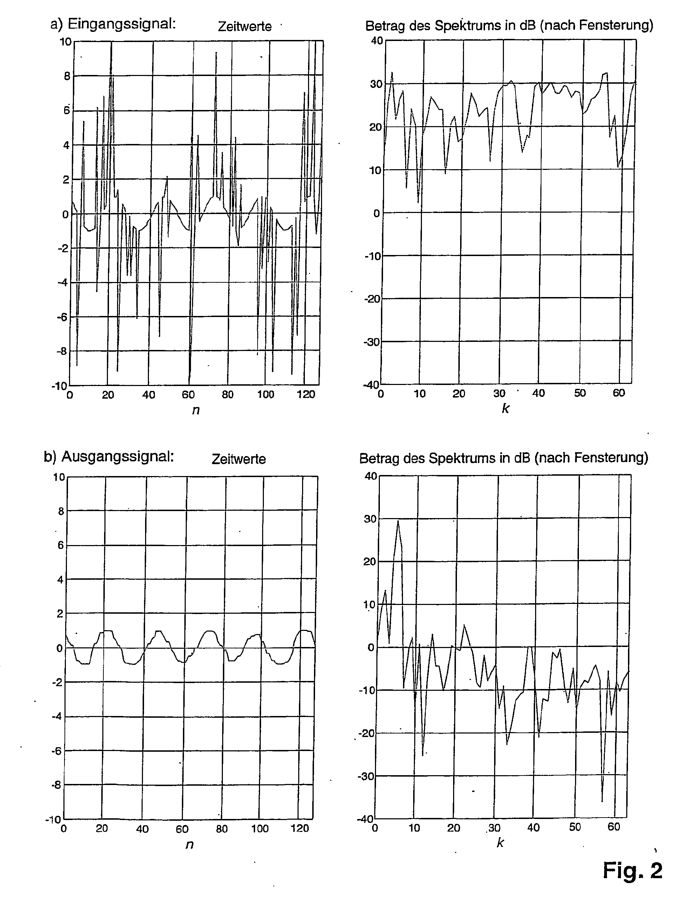

Bei Überreichweiten und Interferenzen durch gepulste, im selben Frequenzbereich arbeitende Systeme sind wegen der Pseudo-Noise-Kodierung der Pulswiederholzeit T_{PW}(n) in jedem Entfernungstor i. Allg. nur einzelne Abtastwerte gestört - man spricht von transienten Störern. Aber dies könnte im Falle hoher Störungen schon reichen, dass die weitere Signalverarbeitung (Spektralanalyse zur Dopplerbestimmung z. B. durch FFT oder Leistungsanalyse z. B. durch Leistungsintegration) unbrauchbare Ergebnisse liefert. Fig. 2a zeigt als Beispiel im diskreten Zeitbereich eine Sinusschwingung, welcher zahlreiche hohe Störimpulse überlagert sind; im Spektrum des resultierenden Signals ist der spektrale Peak der Sinusschwingung in dem von den Störimpulsen erzeugten Rauschen verschwunden.

Hier kommt nun die Medianfilterung zum Einsatz. Die Medianfilterlängen sind vorzugsweise umso höher zu wählen, je mehr Werte gestört sein können; bei einer Leistungsanalyse kann man die Medianfilterlängen bis hin zur Zahl N(m) an Abtastwerten wählen, im Falle einer Spektralanalyse zur Dopplerbestimmung werden die Medianfilterlängen durch die größte zu detektierende Dopplerfrequenz begrenzt (wegen dem Tiefpasscharakter von Medianfiltern), was eine Überabtastung voraussetzt.

Für das in Fig. 2a dargestellte gestörte Signal ergibt sich nach einem zweistufigen Medianfilter mit jeweiliger Filterlänge K = 5 der in Fig. 2b dargestellte Verlauf; das Nutzsignal, eine Sinusschwingung, ist im Zeitbereich fast vollständig wieder rekonstruiert und im Spektrum somit deutlich sichtbar.

Kombiniert man also die Pseudo-Noise-Kodierung der Pulswiederholzeit und die Medianfilterung als eine zur Unterdrückung von transienten Störern geeignete nichtlineare Filterung, so kann man den Einfluss von Überreichweiten und Interferenzen durch gepulste, im selben Frequenzbereich arbeitende Systeme stark vermindern oder gänzlich eliminieren. Zudem ist zunächst vorzugsweise in jedem Entfernungstor eine adäquate Vorverarbeitung der Abtastwerte vorgesehen, wie z. B. eine Betragsquadratbildung für eine Leistungsanalyse.

Nachfolgend soll die Erfindung in ihrer Verwendung in einem Radarsystem insbesondere für ein Personenkraftfahrzeug vorgestellt werden.

Moderne Kraftfahrzeuge sind zunehmend mit einem auf Radar basierenden Abstandsregelsystem ausgestattet, bei dem der Abstand, die Geschwindigkeit und der relative Winkel des vorausfahrenden Kraftfahrtzeuges ermittelt wird.

Ein solches bekanntes Radarsystem ist beispielsweise das von der Firma Bosch entwickelte FMCW-System (Frequency Modulated Continuous Wave), bei dem zwei physikalische Größen, die Entfernung und die Relativgeschwindigkeit eines bewegten oder stehenden Körpers, auf eine physikalische Größe, die Frequenz, abgebildet werden. Zu diesem Zweck werden permanent Signale ausgesendet und die von dem bewegten Körper reflektierten Signale empfangen. Aus dem Frequenzverlauf von gesendetem und empfangenem Signal bzw. aus der Frequenzdifferenz dieser Signale lässt sich auf die gesuchten Größen schließen. Eine Separierung von Geschwindigkeit und Entfernung ist durch Auswertung mehrerer Signale, sogenannte Chirps, mit unterschiedlicher Frequenzsteigung möglich. Für ein einziges Ziel würden zwei Chirps genügen, für Mehrzielsituationen sind wenigstens drei Chirps notwendig.

Zum Betreiben eines solchen Radarsystems ist insbesondere ein Oszillator (VCO) mit geringem Phasenrauschen erforderlich, der möglichst lineare Frequenzrampen bereitstellt, was nicht ohne weiteres möglich ist und wodurch der RF-Teil des Radarsystems sehr aufwendig wird. Bei Verkehrssituationen mit vielen unterschiedlichen Zielen, wie dies durch Leitplanken und im Innenstadtbereich häufig der Fall ist, ergeben sich Probleme bei der Zieldetektion und -trennung, da alle Ziele in einem Antennenstrahl in jedem zugehörigen Chirp-Spektrum vorhanden sind. Eine exakte Extrahierung der unterschiedlichen Ziele ist daher nicht oder nicht immer zufriedenstellend möglich.

Um diese Probleme zu umgehen, bietet sich das Puls-Doppler-Verfahren an. Bei diesem Verfahren wird ein Ziel jeweils auf ein oder mehrere aufeinanderfolgende Entfernungstore abgebildet. Das empfangene Signal wird dabei geeignet abgetastet. Aus dem Amplitudenverhältnis der Abtastwerte in aufeinanderfolgenden Entfernungstoren kann dann auf die genaue Entfernung geschlossen werden.

Allerdings besitzt der Puls-Doppler-System aufgrund der reduzierten mittleren Ausgangsleistung ein geringes Signal-Rausch-Verhältnis (S/N). Aufgrund des breitbandigen Empfangspfads weist dieses Radarsystem auch eine höhere Störbarkeit auf.

Bei dem Puls-Doppler-Verfahren wird, um das Vorzeichen der Geschwindigkeit zu erkennen, eine komplexe Abtastung des empfangenen Signals vorgenommen. Radarsystem nach dem Puls-Doppler-Verfahren zeichnen sich dadurch aus, dass die Geschwindigkeit und die Entfernung direkte Messgrößen darstellen. Der RF-Teil lässt sich im Vergleich zu dem eingangs genannten FMCW-System sehr viel einfacher realisieren, da hier ein freilaufender Oszillator (VCO) mit geringen Anforderungen an sein Phasen- und Amplitudenrauschen benutzt werden kann und keine Frequenzrampen erzeugt werden müssen.

Es werden bei einem solchen Radarsystem für einen Messzyklus eine Vielzahl, beispielsweise 1024, Sendeimpulse pro Empfangsantenne ausgewertet. Deren Abstand beträgt dann z.B. 2.5µs. Der Abstand ist zudem pseudo-noise-kodiert, um Überreichweiten und Interferenzen zu vermeiden.

Bei Verwendung einer hohen Anzahl an Sendeimpulsen ist eine genauere Geschwindigkeitsmessung sowie ein hoher Integrationsgewinn möglich und darüber hinaus ist das aufgrund der Pseudo-Noise-Kodierung erzeugte Rauschen gering, so dass ein optimaleres Signal-Rausch-Verhältnis erreichbar ist.

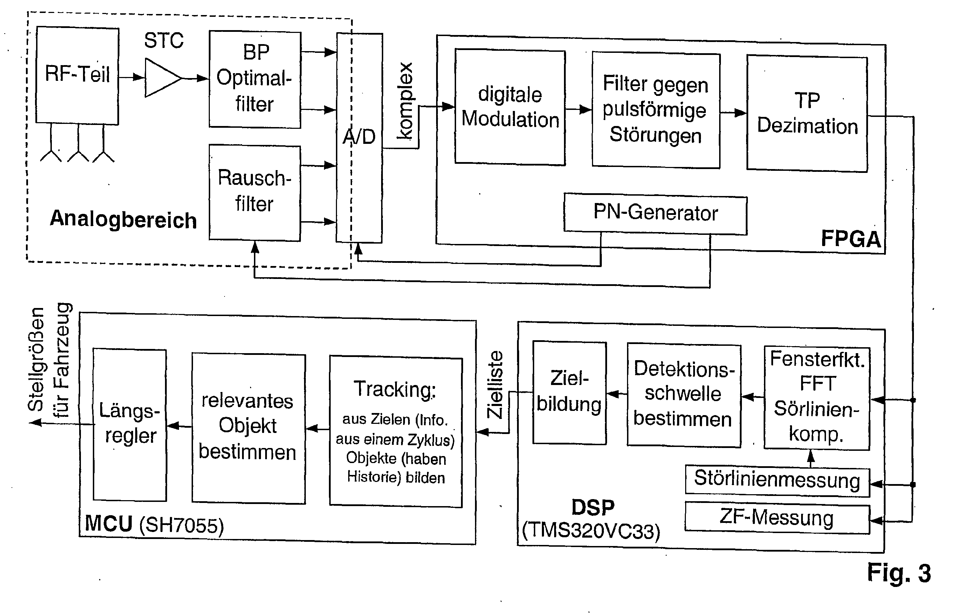

Figur 3 zeigt anhand eines Blockschaltbildes das erfindungsgemäße Puls-Doppler-Radarsystem. Die einzelnen Elemente dieses Systems, insbesondere das Optimalfilter und die Elemente des FPGAs werden anschließend noch detailliert erläutert.

Das Radarsystem weist ein RF-Empfangsteil mit nachgeschaltetem Verstärker, Bandpass-Optimalfilter und A/D-Wandler auf. Am Ausgang des A/D-Wandlers ist ein komplexes Ausgangssignal abgreifbar, welches einem nachgeschalteten FPGA zuführbar ist. Der FPGA besteht aus einer digitalen Modulationseinrichtung, dem Medianfilter gegen pulsförmige Störungen und einem als Tiefpass ausgebildeten Dezimationsfilter, die in Reihe zueinander angeordnet sind. Die FPGA-Einheit enthält außerdem einen PN-Generator. Ferner ist ein Rauschfilter vorgesehen, welches dem A/D-Wandler vorgeschaltet angeordnet ist.

Dem FPGA nachgeschaltet ist ein digitaler Signal-Prozessor (DSP), der im vorliegenden Fall eine Einrichtung zur Erzeugung einer Fensterfunktion, eine FFT-Einrichtung (Fast-Fourier-Transformation) sowie einen Störlinienkompensator aufweist. Anschließend wird ausgehend davon die Detektionsschwelle bestimmt und einer Einrichtung zur Zielbildung, die eine Zielliste erzeugt, zugeführt. Dem DSP nachgeschaltet ist eine Mikrocontrollereinheit (MCU), die ausgehend von der Zielliste im Bedarfsfall Stellgrößen für das Fahrzeug erzeugt. Zu diesem Zwecke wird zunächst ein "Tracking" der Zielliste vorgenommen und ein relevantes Objekt bestimmt. Die Information darüber wird einem Längsregler zugeführt, der dann die gewünschten Stellgrößen erzeugt. Die Funktion des DSP und der MCU können selbstverständlich auch durch eine einzige programmgesteuerte Einheit, beispielsweise einen Mikrocomputer, erfüllt werden.

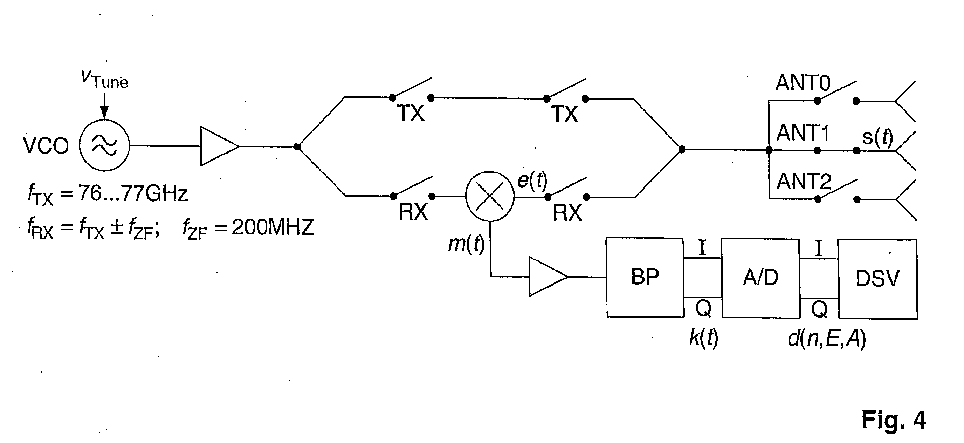

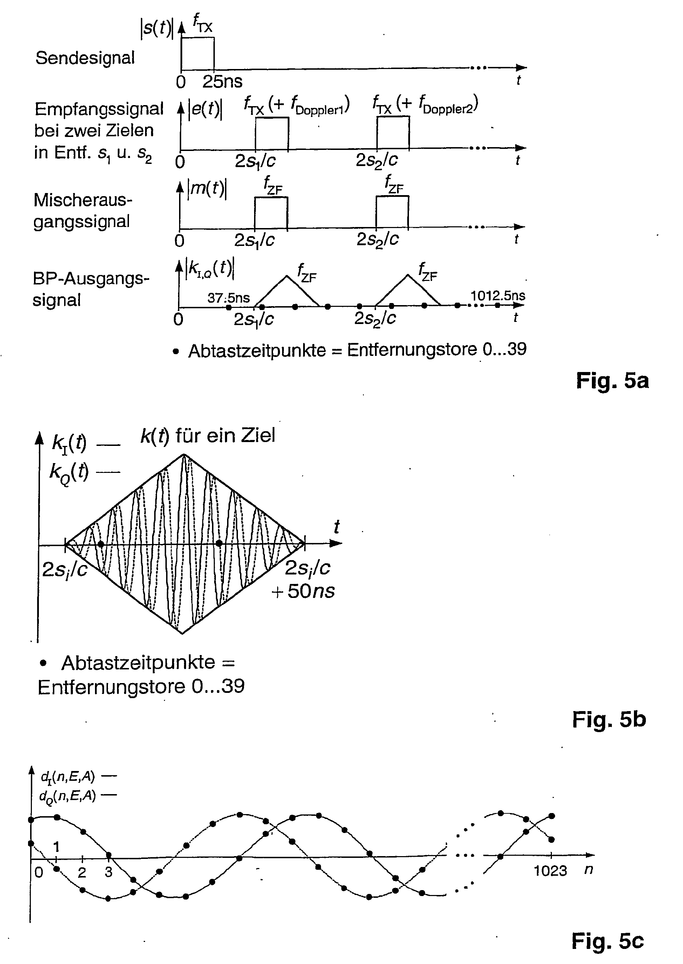

Nachfolgend soll anhand der Figuren 4 und 5 das Doppler-Verfahren kurz erläutert werden. Dabei zeigt Figur 4 anhand eines vereinfachten Schaltbildes das Prinzip des Doppler-Verfahrens und Figur 5 die Signal-Zeit-Diagramme für das Schaltbild nach Figur 4.

Bei dem Doppler-Verfahren wird eine komplexe Abtastung des empfangenen Signals vorgenommen, um das Vorzeichen der Geschwindigkeit zu erkennen. Radarsystem mit dem Puls-Doppler-Verfahren zeichnen sich dadurch aus, dass die Geschwindigkeit und die Entfernung direkte Messgrößen darstellen. Das RF-Teil lässt sich dadurch im Vergleich zu dem eingangs genannten FMCW-System sehr viel einfacher realisieren, da hier ein freilaufender Oszillator (VCO) mit geringen Anforderungen an sein Phasen- und Amplitudenrauschen verwendet werden kann und keine Frequenzrampen erzeugt werden müssen.

Ein Messzyklus dauert bspw. jeweils 50ms. Das Messergebnis ist eine Zielliste, d.h. eine Momentaufnahme der Verkehrssituation. Jedem Messzyklus sind 5 Messblöcke, nämlich ein Störlinienmessblock, ein ZF-Messblock sowie drei Antennenmessblöcke (für jede Antenne einer), zugeordnet. Jeder dieser Messblöcke dauert 2,76ms. In dieser Zeit werden beispielsweise 1024 + 64 Sendeimpulse erzeugt, wobei die ersten 64 Sendeimpulse dem Einschwingen der Filter dienen und somit nicht verwertet werden. Nach jedem Sendeimpuls wird 40 Mal im Abstand von jeweils 25ns abgetastet. Damit wird sichergestellt, dass jedes Ziel zumindest in einem Entfernungstor erfasst wird.

Über die Schalter ANTO bis ANT2 wird eine der drei Antennen ausgewählt. Durch Schließen der Sendeschalter TX für 25ns wird das Signal des Oszillators auf die ausgewählte Antenne gegeben und abgestrahlt.

Nach diesem Aussenden eines rechteckförmigen Sendeimpulses werden die Empfangsschalter RX geschlossen, und die Frequenz des Oszillators wird um 200MHz geändert. Dadurch werden die Empfangsimpulse über den Mischer auf eine Zwischenfrequenz von 200MHz transformiert. Die Dopplerverschiebung der Frequenz kann an dieser Stelle unberücksichtigt bleiben. Das so resultierende reelle Signal m(t) wird auf einen als Optimalfilter ausgelegten passiven Bandpass gegeben, welcher zwei zueinander orthogonale Ausgänge gleicher Amplitude besitzt und somit das komplexe Signal k(t) erzeugt, d. h., es wird ein IQ-Signal ohne komplexe Mischung realisiert.

Das IQ-Signal am Ausgang des Bandpassfilters wird nach jedem Sendeimpuls 40mal in Abständen von 25ns abgetastet. Die einzelnen Abtastzeitpunkte korrespondieren zu jeweils einem Entfernungsbereich - sie stellen damit sogenannte Entfernungstore dar, welche eine Breite von 3.75m besitzen und bis zu einer Entfernung von 150m reichen. Da ein rechteckförmiger Empfangsimpuls der Länge 25ns durch das Bandpassfilter zu einem dreieckförmigen Impuls der doppelten Länge verschliffen wird und somit i. Allg. in zwei aufeinanderfolgenden Entfernungstoren sichtbar ist, kann durch Auswerten der Amplitudenverhältnisse dieser zwei Entfernungstore die genaue Entfernung interpoliert werden.

Für die Ermittlung der Relativgeschwindigkeit der Ziele bezüglich des eigenen Fahrzeugs und zur Erhöhung des Signal-Rausch-Verhältnisses werden die komplexen Empfangssignale von 1024 aufeinanderfolgenden Sendeimpulsen in jedem Entfernungstor E ausgewertet, ohne dabei die selektierte Antenne A zu ändern. Für den Fall äquidistanter Sendeimpulse zeigt Bild 4 den Real- und Imaginärteil d_{I}(n,E,A) und d_{Q}(n,E,A) der 1024 komplexen Abtastwerte d(n,E,A) eines Entfernungstors, in welchem sich ein relativ bewegtes Ziel befindet (während der kurzen Beobachtungsdauer von 2.56ms für die 1024 Abtastwert kann die Relativgeschwindigkeit stets als konstant betrachtet werden); von Abtastwert zu Abtastwert ändert sich die Phase gleichförmig, da sich die Entfernung des Ziels und somit die Phase des Empfangsimpulses gleichförmig ändern- es resultiert genau die Dopplerfrequenz inklusive ihrem Vorzeichen (weil das Signal komplex ist).

Das eben beschriebene Verfahren wird sequentiell für jede der drei Antennen angewendet. Eine der Antennen schaut genau geradeaus, während die zwei anderen leicht nach links bzw. rechts gerichtet sind, um so die Position der erfassten Ziele relativ zur eigenen Fahrspur bestimmen zu können.

Das empfangene Signal enthält immer auch einen Störungsanteil, der sich als Rauschen bemerkbar macht. Die Störung weist näherungsweise die Charakteristik von weißem Rauschen auf. Um dieses Rauschen möglichst gut herauszufiltern, d. h. ein maximales Signal-Rausch-Verhältnis zu erzielen, wird ein Optimalfilter benutzt. Seine Übertragungsfunktion entspricht dem Spektrum der empfangenen Zwischenfrequenzimpulse (ZF-Impulse), d h. dem Spektrum eines mit 200MHz modulierten Rechtecks der Impulslänge 25ns. Das Optimalfilter entspricht somit einem Bandpass.

Das verwendete Optimalfilter wird vorteilhafterweise als ein in ohmsche Widerstände eingebetteter LC-Vierpol realisiert. Im betrachteten Frequenzbereich ist dies eine besonders günstige und flexible Technologie, da die hierfür benötigten Induktivitäten als SMD-Bauteile verfügbar sind. Die Filterschaltung kann dadurch sehr einfach, klein und damit auch kostengünstig aufgebaut werden.

Beim Entwurf eines solchen Optimalfilters nach dem bekannten Verfahren nach Bader sind zwei Entwurfsstrategien möglich:
1. Zunächst wird ein bedarfsgemäß angepasster Tiefpass entworfen. Anschließend wird daraus eine Transformation des Tiefpasses in einen Bandpass vorgenommen. Diese Variante eignet sich allerdings nur bedingt und auch nur für spezielle Schaltungen, da sie zu für die Realisierung der Schaltung ungeeigneten Strukturen und Bauteilewerten führt.
2. Direkter Entwurf eines Bandpassfilters: Diese Variante ist besonders vorteilhaft, wenngleich auch beim Entwurf etwas aufwendiger, da sie zu unterschiedlichen alternativen Strukturen führt, die je nach Anforderungen mehr oder weniger gut an die geforderten Verhältnisse angepasst sind. Bei diesem Verfahren wird zunächst eine Approximation der idealen Übertragungsfunktion vorgenommen.

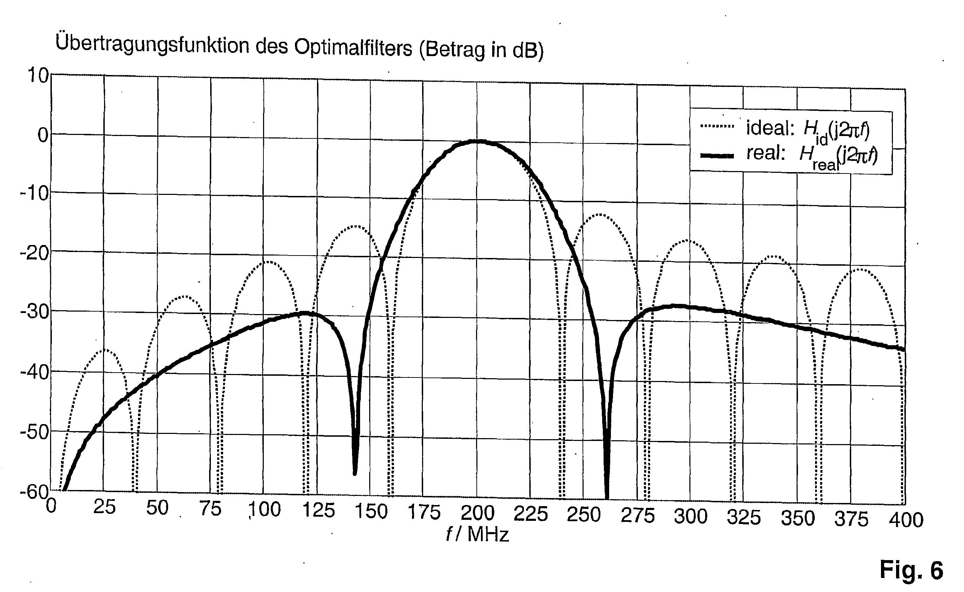

Fig. 6 zeigt gestrichelt die Übertragungsfunktion eines im direkten Entwurf hergestellten Optimalfilters; die dünne durchgehende Kurve gehört zum idealen Optimalfilter, welches durch die reale Schaltung sehr gut angenähert bzw. nachgebildet wird.

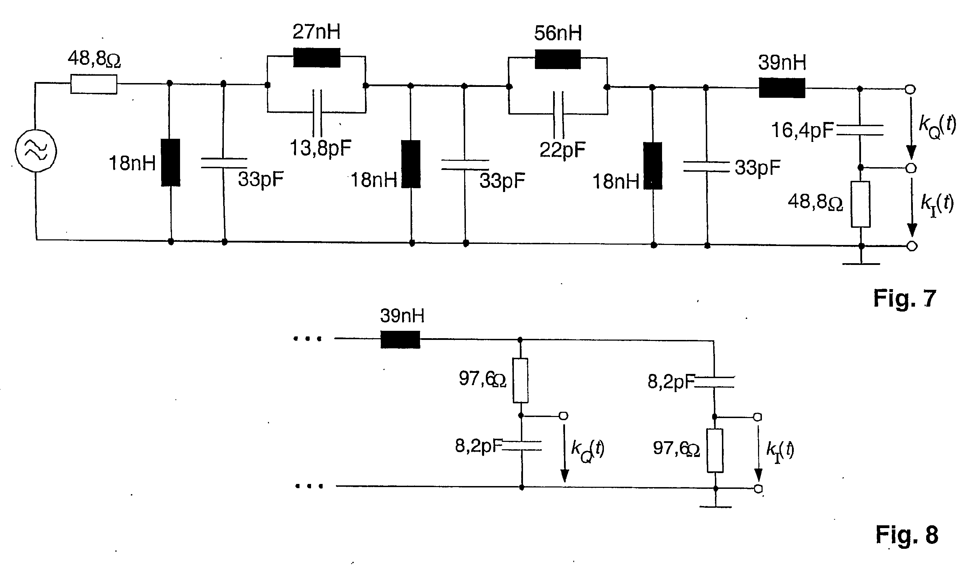

Die Figur 7 zeigt eine erste Schaltungsanordnung für die Realisierung eines nach Bader approximierten Optimalfilters: Die Werte der Induktivitäten, Kapazitäten und Widerstände sind hier auf real verfügbare Werte gerundet. Freiheitsgrade bei Entwicklung wurden hier so ausgenutzt, dass vorteilhafterweise kein Übertrager notwendig ist. Die in Figur 7 dargestellte Struktur hat im Gegensatz zu ihrer dualen Struktur von fast allen Knoten Kapazitäten gegen Masse, in welche die Streukapazitäten mit eingerechnet werden können.

Die Ausgangssignale k_{I}(t) und k_{Q}(t) der Schaltung in Figur 7 stehen orthogonal zueinander, d.h. sie weisen eine Phasendifferenz von 90° zueinander auf, und besitzen bei der Zwischenfrequenz f_{ZF}=200MHz gleiche Amplitude, was durch Freiheitsgrade bei Entwicklung erreichbar ist.

Das komplexe Ausgangssignal kₗ(t) + j*k_{Q}(t), nachfolgend IQ-Signal genannt, stellt damit eine komplexe Schwingung für die reelle Eingangsschwingung mit der Zwischenfrequenz f_{ZF} dar. Dieses sogenannte IQ-Signal wurde vorteilhafter Weise ohne jegliche Mischung realisiert.

Besonders vorteilhaft ist es, wenn sowohl der dem Realteil als auch dem Imaginärteil zugeordnete Teil des Ausgangssignals, also k_{I}(t) und k_{Q}(t), gegen Masse ausgebildet sind. Figur 6 zeigt anhand eines Schaltbildes ein zweites, bevorzugten Ausführungsbeispiels eines approximierten Optimalfilters, bei dem dieser Forderung Rechnung getragen wird. Die ausgangsseitige Teil der Filterschaltung wurde dabei im Wesentlichen aufgedoppelt.

Diese in Figur dargestellte modifizierte Ausgangsstufe hat den weiteren großen Vorteil, dass trotz ohmscher und kapazitiver Belastung durch den A/D-Wandler der I/Q-Charakter des Ausgangssignals erhalten bleibt. Lediglich die Filtercharakteristik ändert sich geringfügig.

Ein entsprechend den Figuren 7 und 8 ausgebildetes Bandpass-Optimalfilter weist zusammenfassend also die folgenden vorteilhaften Funktionen auf:
- Das Filter weist ein optimiertes Signal-Rausch-Verhältnis auf.
- Das Filter erzeugt auf einfache, jedoch sehr zuverlässige Weise ein weitestgehend exaktes IQ-Signal, welches am Ausgang des Filters abgreifbar ist.
- Da das dreieckförmige Ausgangssignal in zwei Entfernungstoren sichtbar ist und über das Amplitudenverhältnis die Entfernung bestimmt werden kann, ist auf diese Weise eine einfache Interpolation der Entfernung möglich.

Der FPGA-Block in Figur 3 weist eine Einrichtung zur digitalen Modulation des von dem Optimalfilter erzeugten komplexen Ausgangssignals auf. Eine derartige Einrichtung ist erforderlich, da der interessierende Geschwindigkeitsbereich typischerweise nicht symmetrisch ist und damit zu einem unsymmetrischen Frequenzbereich führen würde; im Anwendungsbeispiel interessieren Geschwindigkeiten im Bereich von -88,2 bis +264,7 km/h. Mittels eines Frequenzoffsets von -12.5kHz lässt sich daraus ein symmetrischer Frequenzbereich erzeugen. Mittels einer geeignet dimensionierten Einrichtung zur digitalen Modulation lässt sich dies realisieren, beispielsweise durch Multiplikation des abgetasteten IQ-Signals mit einem Signal, welches von einem umlaufenden komplexen Zeiger der Amplitude 1 und der Drehfrequenz -12.5kHz erzeugt wird.

Der FPGA-Block weist ferner ein nichtlineares Filter gegen pulsförmige Störungen auf. Pulsförmige Störungen haben ihren Ursprung z.B. in Überreichweiten oder Puls-Radar-Systemen anderer Verkehrsteilnehmer. Durch eine Pseudo-Noise-Kodierung der Abtastzeitpunkte werden pulsförmige Störungen auf alle Entfernungstore (mehr oder weniger gleichmäßig) verteilt. Dadurch sind nur einzelne Werte in jedem Entfernungstor gestört. Durch Pseudo-Noise-Kodierung und nichtlineare Filterung, beispielsweise durch Medianfilter, lassen sich unerwünschte pulsförmige Störungen kompensieren.

Für die Realisierung des Filters gegen pulsförmige Störungen ist folgende Problematik zu berücksichtigen:
Ein lineares Filter ist hier wenig vorteilhaft, da der dem Filter nachfolgende Dezimationstiefpass bereits ein lineares Filter mit minimaler Bandbreite darstellt. Denkbar sind alle nichtlinearen Filter, welche einzelne Fehlwerte kompensieren können; viele dieser Filter sind allerdings hinsichtlich der Stabilität und der Implementierung auf einem FPGA problematisch.

Hier ist vorteilhafter Weise ein ein- oder mehrstufiges Medianfilter zu verwenden. In einer bevorzugten Ausgestaltung ist dieses Filter zweistufig mit jeweils die Länge 5. Vorteilhafterweise wird durch den vorgeschalteten A/D-Wandler eine Überabtastung vorgenommen.

Der Median von K Werten ist der mittlere Wert, d.h. der (K+1)/2-kleinste Wert = (K+1)/2-größte Wert.

Zum Beispiel ist der Median der fünf Zahlen 5, 3, 2, 79, 1 gleich 3. Ein gleitendes Medianfilter ohne Reduktion der Abtastrate berechnet zu jedem Zeitpunkt n den Median von K aufeinander folgender Werte einer Eingangsfolge x(n) und erzeugt daraus ein Ausgangssignal m(n). Für Median-Filter sind viele Algorithmen bekannt, welche sich insbesondere für eine Software-Realisierung eignen. Diese basieren auf Sortierung mit einhergehender hoher Rechenzeit oder statistische Auswertung mit einhergehendem hohen Speicherbedarf von Daten. Für eine Hardware-Realisierung sind diese Algorithmen wenig geeignet, da sie typischerweise zu viele Fallunterscheidungen und Verzweigungen benötigen.

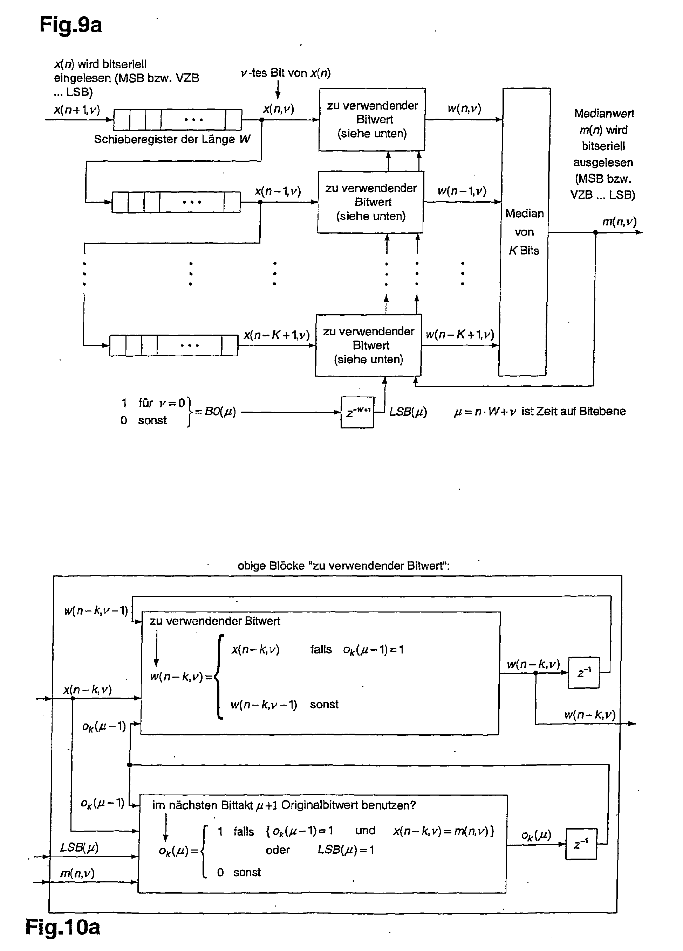

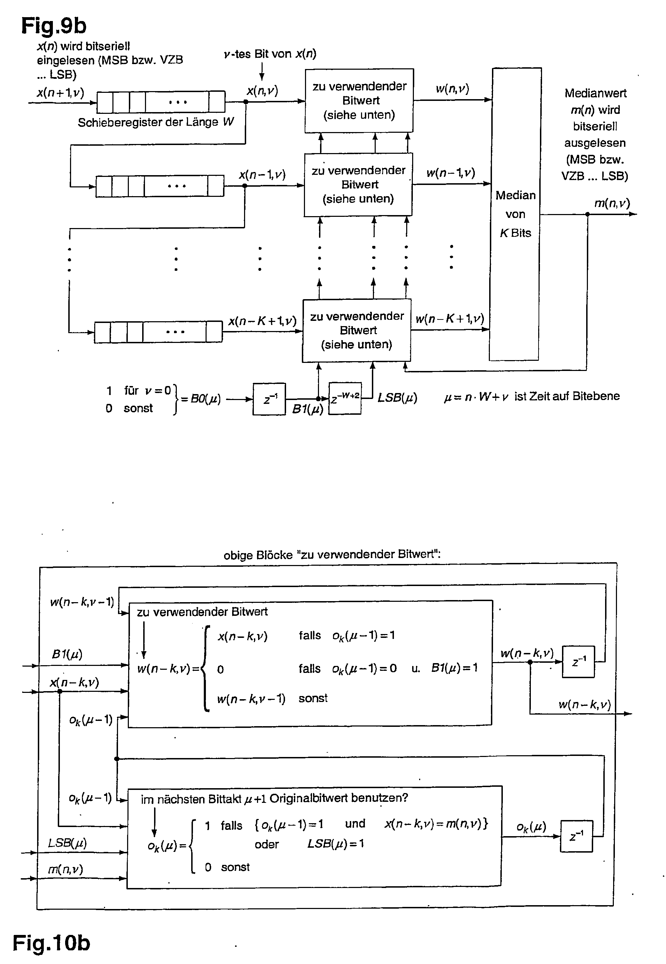

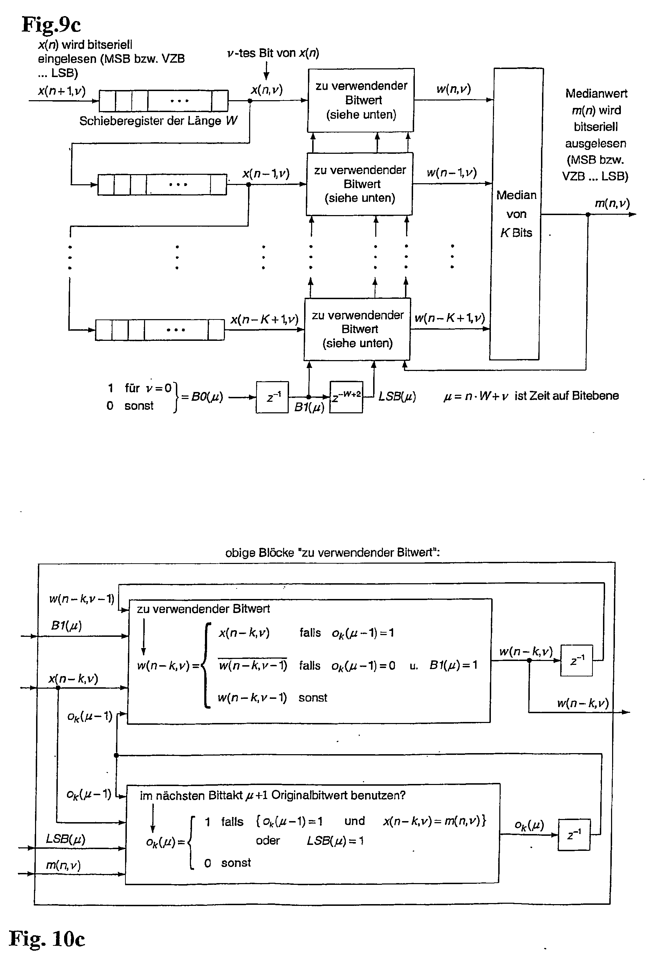

Es wurde jedoch nun ein neuer Algorithmus für eine Hardware-Realisierung eines Median-Filters entwickelt: Die Funktionsweise sei nachfolgend anhand der Figuren 9a,9b,9c und 10a,10b,10c dargestellt.

Sie zeigen einen Algorithmus zur Implementierung einer bitseriellen Abarbeitung zur Bestimmung des Medians. Mit einer solchen Struktur kann in vielen Fällen der Aufwand eines Median-Filters deutlich reduziert werden, insbesondere wenn die maximale Taktzeit des FPGAs wesentlich größer als der Worttakt des Eingangssignals ist. Ein weiterer Vorteil besteht in der einfachen Skalierbarkeit der Struktur.

In den Figuren 9a,9b,9c sowie die Fig. 10a, 10b und 10c sind Varianten des Filteralgorithmus zur Medianberechnung in Form eines eindimensionalen Filters ohne Dezimation dargestellt, wobei die Fig.9a in Verbindung mit Fig.10a den Aufbau für Eingangswerte in vorzeichenloser Binärdarstellung zeigen, während die Fig.9b in Verbindung mit Fig.10b die Abwandlung für eine Vorzeichen-Betrags-Darstellung der Eingangswerte und die Fig.9c in Verbindung mit Fig.10c die Abwandlung für eine Einer- oder Zweier-Komplement-Darstellung der Eingangswerte verdeutlichen. Zur Erläuterung seien folgende Punkte angemerkt:
Das Eingangssignal x(n) und das Ausgangssignal bestehend aus den Medianwerten m(n) besitzen die Wortlänge W, d. h. jeder Zeitwert besteht aus W Bits. Die einzelnen Bits werden mit ν nummeriert, beginnend bei ν = 0 für das MSB (bei vorzeichenloser Binärdarstellung in Fig.9a,10a sowie Einer- und Zweierkomplementdarstellung in Fig.9c,10c) bzw. das VZB (bei Vorzeichen-Betrag-Darstellung in Fig.9b,10b) und endend bei ν = W-1 für das LSB. Das Bit ν von x(n) bzw. m(n) wird mit x(n,v) bzw. m(n,v) bezeichnet.
Die Zeit auf Ebene der Ein- und Ausgangssignale, d. h. Wortebene, wird mit n bezeichnet, die Zeit auf Bitebene mit µ = n-W +ν.
Die Verarbeitung ist bitseriell, d. h. ein Bit nach dem anderen wird bearbeitet, beginnend beim MSB bzw. VZB und endend beim LSB. Die gesamte Filterstruktur, d. h. Speicher und Logik, werden also mit der Bitzeit µ getaktet.
Die zur Medianberechnung benötigten Eingangswerte werden bitweise mit Hilfe von K aufeinanderfolgenden Schieberegistern der Länge W gespeichert; dabei ist K die Medianfilterlänge.

Das Flag B0(µ) kennzeichnet die Verarbeitung vom Bit 0; es ist 1 für ν = 0 und sonst 0. Die Flags B1 (µ) und LSB(µ) kennzeichnen die Verarbeitung vom Bit 1 bzw. vom LSB; sie sind in analoger Weise definiert und lassen sich durch Verzögerung von 80(µ) um einen bzw. W-1 Takte generieren.

Im Block "Median von K Bits" findet die bitweise Medianbildung statt, d. h. die Majorität von Nullen oder Einsen unter den K eingespeisten Bits wird bestimmt.

Im k-ten Block "zu verwendender Bitwert" (k = 0,1,...,K-1 ist von oben gesehen), welcher im Detail jeweils in den Figuren 10a, 10b und 10c gezeigt ist, wird zum einen der k-te Bitwert w(n-k,v) für die bitweise Medianbildung bestimmt: dies ist entweder der Originalwert x(n-k,v), d. h. vom Eingangswert x(n-k) das betrachtete Bit v, oder ein entsprechend modifizierter Wert. Zum anderen wird ermittelt, ob im nächsten Bittakt µ+1 der Originalwert oder ein entsprechend modifizierter Wert zu verwenden ist, was durch das Flag ok(µ) = 1 für die bisher nicht erfolgte Modifizierung bzw. ok(µ) = 0 für die bereits erfolgte Modifizierung gekennzeichnet wird. Dabei ist die aus dem oben beschriebenen Vorgehen folgende Regel berücksichtigt, dass nach der ersten Verwendung eines modifizierten Wertes dieser auch nachfolgend bis zum Ende des jeweiligen Zeitschrittes n zu verwenden ist. Anschließend, d. h. bei LSB(µ)=1 wird das Flag wieder zurückgesetzt, d. h. für den nächsten Ausgangswert wird zunächst wieder der unmodifizierte Eingangswert berücksichtigt.

Die Initialisierung der Speicher (Schieberegister sowie Verzögerer) ist abhängig vom gewünschten Anlaufverhalten des Filters.

Im folgenden soll diese neue Medianfilterstruktur bzgl. ihres Aufwandes bei einer Hardware-Realisierung (z. B. auf einem ASIC oder FPGA) betrachtet werden:

Die bitweise Medianbildung, d. h. die Bestimmung der Majorität von Nullen oder Einsen unter den K eingespeisten Bits, ist zentraler Block dieser Struktur. Eine mögliche, insbesondere für größere Filterlängen K geeignete Strategie zur Realisierung dieses Blocks basiert auf der Summenbildung der Bitwerte (sind 0 oder 1). Ist die Bitsumme >= (K+1)/2, so ist der Bitmedian gleich 1, ansonsten 0; den Vergleich kann man über eine Subtraktion und anschließende Abprüfung auf das Vorzeichen implementieren. Die Bitsummenbildung kann z. B. in gestufter paralleler Form realisiert werden, bei welcher von Stufe zu Stufe die Zahl der parallelen Einzeladdierer ab- und ihre Wortlänge zunimmt; dadurch lassen sich einerseits der kritische Pfad und damit die benötigte Durchlaufzeit minimieren sowie andererseits die benötigten Wortlängen und damit der Aufwand möglichst klein halten. Die Minimierung des kritischen Pfads ist besonders dann wichtig, wenn eine hohe Taktzeit des Filters gefordert ist, da die bitweise Medianbildung in einer rekursiven Schleife liegt und deshalb ein Pipelining ausscheidet. Für kleine Filterlängen gibt es zur Realisierung der bitweisen Medianbildung spezielle, auf die benutzte Hardware optimierte Lösungen. Als Beispiel betrachtet sei die Filterlänge K = 5 und die Realisierung auf einem marktüblichen FPGA, welches als Grundbaustein Look-Up-Tables (LUTs) mit vier logischen Eingängen und einem logische Ausgang besitzt; es werden dann drei solcher LUTs für die bitweise Medianbildung benötigt.

Die K identischen Blöcke "zu verwendender Bitwert" benötigen jeweils nur zwei Verzögerer (FIFOs) sowie eine sehr einfache Logik (im obigem Beispiel 2 LUTs).

Die K Schieberegister zur Speicherung der Eingangswerte benötigen in vielen Fällen (insbesondere wenn die Wortlänge W relativ groß ist) wesentlich mehr Aufwand als der Rest der Filterstruktur, was für die Effizienz der Filterlogik spricht. Es sei bemerkt, dass eine Speicherung von K Eingangswerten in jedem Medianfilter unabhängig von der Struktur notwendig ist.

Die neue Medianfilterstruktur ist skalierbar, sofern die bitweise Medianbestimmung über eine Summenbildung realisiert ist; bei Änderung der Filterlänge K sind nur die Zahl der verwendeten Schieberegister, die Zahl der identischen Blöcke "zu verwendender Bitwert" und die Zahl der aufzusummierenden Bits sowie der mit der Bitsumme zu vergleichende Wert anzupassen.

Die neue Medianfilterstruktur hat die Eigenschaft, dass die Medianbildung für jeden Eingangswert, d. h. jeden Zeitschritt n, ganz neu aufsetzt, also im Gegensatz zu den meisten gebräuchlichen Strukturen nicht auf Ergebnisse früherer Zeitschritte zurückgreift; beispielsweise wird bei Sortierverfahren i. Alig. von der im vorhergehenden Zyklus bestimmten Reihenfolge ausgegangen. Wegen dieser Eigenschaft eignet sich der neue Algorithmus zur Medianberechnung in ganz besonderem Maße für eine Filterung mit Dezimation. Dazu sind in der Filterstruktur nur die Schieberegister in modifizierter Weise zu speisen. So sind bei einer Dezimation um den Faktor L = 2 die zwei obersten Schieberegister parallel mit zwei aufeinanderfolgenden Eingangswerten zu speisen, und bei der Verkopplung der Schieberegister wird jeweils eins übersprungen. Bei einer Dezimation um die Medianfilterlänge, d. h. L = K, sind die Schieberegister nicht mehr verkoppelt, sondern werden parallel mit K aufeinanderfolgenden Eingangswerten gespeist. Durch Dezimation kann die von der Filterstruktur maximal prozessierbare Taktrate des Eingangssignals x(n) um den Dezimationsfaktor L erhöht werden.

Für Hardware-Realisierungen des digitalen Filters führt der neue Algorithmus zur Medianberechnung in vielen Fällen zu einer beträchtlichen Reduktion des benötigten Aufwands; dies ist hauptsächlich abhängig von der Taktrate sowie der Wortlänge des Eingangssignals, dem Grad der Dezimation und der verwendeten Technologie bzw. verfügbaren Logik.

Der FPGA-Block in Figur 3 weist ferner ein Dezimationsfilter auf. Das Dezimationsfilter ist vorteilhafterweise als Tiefpass ausgebildet.

Im vorliegenden Ausführungsbeispiel wird eine Dezimation der Abtastfrequenz von 400kHz auf 50kHz, also um den Faktor 8, vorgenommen. Dadurch ist - im Falle eines idealen Dezimationstiefpasses - eine Verbesserung des Signal-Rausch-Verhältnisses um 9dB möglich.

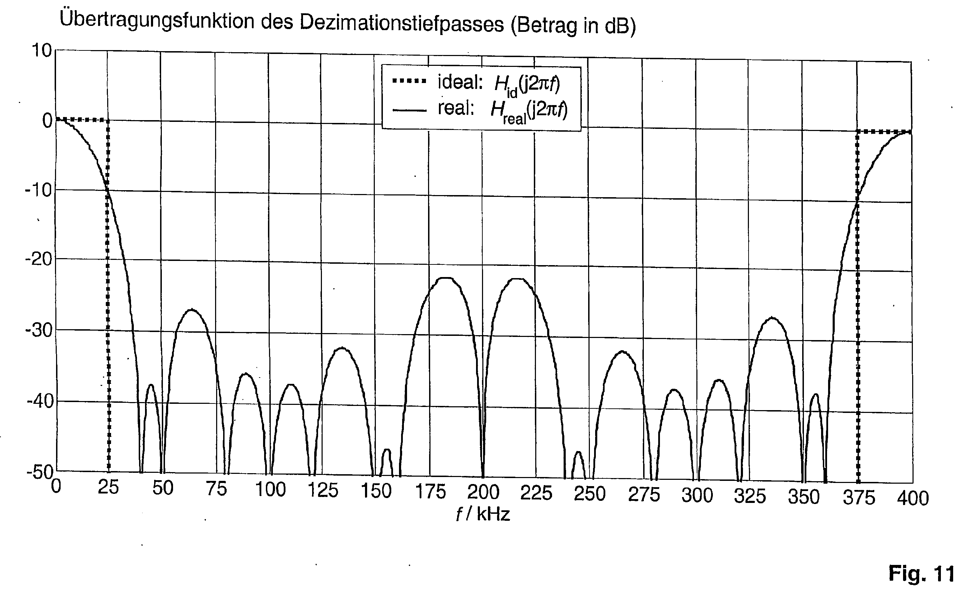

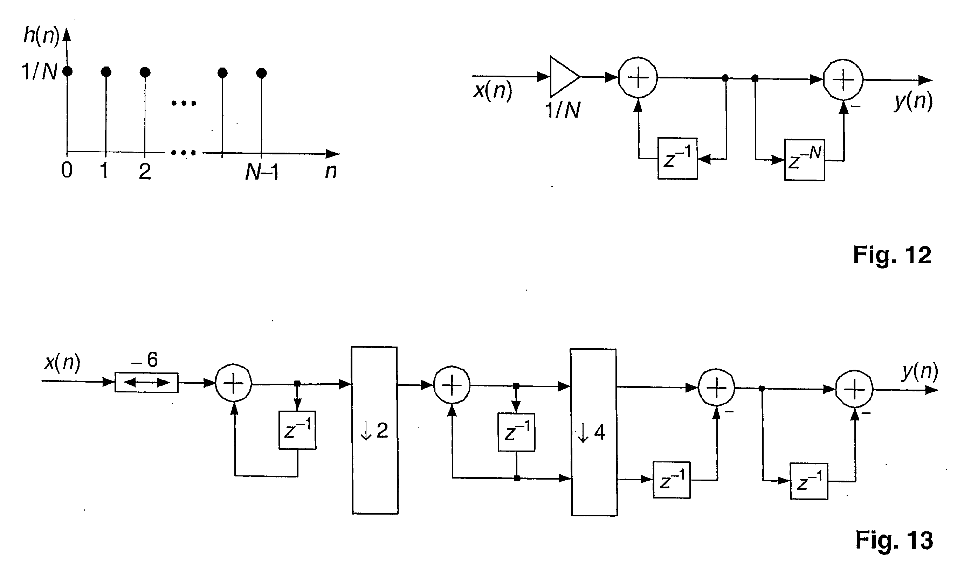

Ein realer Dezimationstiefpass muss die Anforderung möglichst steiler Flanken um die Frequenzen f = ± 25kHz herum erfüllen. Nicht erforderlich ist |Hᵣₑₐₗ(j2πf)| ≈ const im Durchlassbereich |f| < 25kHz, da bei der Auswertung lediglich Spektren verwertet werden und dabei auf einfache Weise Amplitudenfehler kompensiert werden können. In der Figur 11 ist die Übertragungsfunktion eines idealen und eines realen Dezimationstiefpasses dargestellt. Der dafür verwendete Tiefpass besteht aus zwei gleitenden Mittelwertbildnern, wobei der zweite schon mit der halbierten Eingangstaktrate arbeitet. Der gleitende Mittelwertbildner der Länge N mittelt über den aktuellen und die N-1 vorhergehenden Werte. Figur 12 zeigt die Impulsantwort h(n) eines solchen gleitenden Mittelwertbildners sowie ein Signalflussdiagramm. Der Mittelwertbildner lässt sich sehr effizient in rekursiver Form realisieren.

Die Gesamtstruktur eines vorteilhaften Ausführungsbeispiels eines Dezimationstiefpasses ist in Figur 13 dargestellt. Ein fehlender Faktor 64/40 am Ausgang wird bei einer späterer Fensterung für die digitale Fourier-Transformation (DFT) mit realisiert. Für ein solches Dezimationsfilter mit dem Grad 15 müssen also folgende Elemente bereitgestellt werden: ein Shifter, vier Addierer, vier Speicherelemente. Ein Multiplizierer ist aber nicht erforderlich. Im Vergleich dazu müssen bei einem üblichen linearphasigen Filter mit dem Grad 15 insgesamt acht Multiplizierer, 15 Addierer, 15 Speicher bereitgestellt werden. Das Dezimationsfilter zeichnet sich also auch durch einen deutlich geringeren schaltungstechnischen Aufwand aus.

Im vorstehenden Beispiel wurde ein Medianfilter zur Unterdrückung transienter Störungen verwendet. Nachfolgend sollen alternative nichtlineare digitale Filterverfahren vorgestellt werden. So wird beispielsweise sukzessive zu jedem Abtastwert aus den ihm vorausgehenden Abtastwerten durch Extrapolation ein Schätzwert bestimmt, der betrachtete Abtastwert wird mit seinem Schätzwert verglichen und bei einer Abweichung des betrachteten Abtastwert von seinem Schätzwert um mehr als eine vorgegebene Schwelle, dieser Abtastwert als transient gestört erkannt und durch seinen Schätzwert ersetzt.

Wird, wie im vorher beschriebenen Anwendungsfall aus dem empfangenen Reflexionssignal ein komplexes Signal mit einem I-Anteil und einem Q-Anteil erzeugt, kann alternativ auch jeweils für einen Abtastwert aus dem I- und Q-Anteil die Leistung ermittelt und mit einem über mehrere zurückliegende Abtastwerte gemittelten Leistungswert verglichen und bei Abweichung der Leistung über einen vorgegebenen Schwellwert der aktuelle Abtastwert als transient gestört erkannt und durch einen aus den vorhergehenden Abtastwerten extrapolierten Wert ersetzt werden.

## Patentansprüche

1. Verfahren zur Unterdrückung von Störungen in Systemen zur Objekterfassung in einem Zielgebiet, bei dem:
a) mit zumindest einem Sender (ANTO,ANT1,ANT2) eine Folge von Impulsen (s(t)) in das Zielgebiet gesendet und mit zumindest einem Empfänger die Reflexionssignale (e(t)) der Impulse innerhalb mehrerer Zeitfenster erfasst werden, wobei die Zeitfenster jeweils in Bezug auf den Zeitpunkt der Absendung der einzelnen Impulse ausgerichtet werden und so jeweils ein Entfernungstor darstellen, wobei
b) der zeitliche Abstand (T_{PW}(n)=tₚ(n+1)-tₚ(n)) zwischen den einzelnen Impulsen (tₚ(n+1),tₚ(n)) nach Pseudo-Noise-Prinzip innerhalb vorgegebener Grenzen zufallscodiert ist und die Zeitfenster entsprechend angepasst werden
c) und eine Abtastung, eine Digitalisierung, gegebenenfalls eine digitale Vorverarbeitung und nachfolgend eine digitale Filterung des empfangenen Reflexionssignals in den einzelnen Entfernungstoren erfolgt, wobei für die Filterung ein nichtlineares digitales Filter zur Unterdrückung transienter Störungen verwendet wird.

2. Verfahren nach Anspruch 1, wobei für die nichtlineare digitale Filterung ein Medianfilter verwendet wird, bei dem aus jeweils einer ungeraden Anzahl von aufeinanderfolgenden Abtastwerten eines innerhalb eines Entfernungstors erfassten Reflexionssignals der Median bestimmt wird.

3. Verfahren nach Anspruch 2, wobei ein Medianfilter der Länge zwischen 3 bis 9 verwendet wird.

4. Verfahren nach Anspruch 2 oder 3, wobei ein mehrstufiges Medianfilter verwendet wird.

5. Verfahren nach einem der Ansprüche 2 bis 4, wobei ein zweistufiges Medianfilter mit jeweils der Länge 5 verwendet wird.

6. Verfahren nach einem der Ansprüche 2 bis 5, wobei ein gleitendes Medianfilter mit sich überlappenden Fenstern der Eingangswerte verwendet wird.

7. Verfahren nach einem der vorangehenden Ansprüche, wobei innerhalb jedes Entfernungstors eine Überabtastung erfolgt.

8. Verfahren nach einem der vorangehenden Ansprüche, wobei eine Spektralanalyse mit vorgeschalteter Dezimationsfilterung des mediangefilterten Reflexionssignals erfolgt.

9. Verfahren nach einem der vorangehenden Ansprüche, wobei eine Leistungsanalyse des mediangefilterten Reflexionssignals erfolgt.

10. Verfahren nach einem der vorangehenden Ansprüche, **dadurch gekennzeichnet, dass** das Reflexionssignal erfasst und abgetastet wird, in einem Analog-Digital-Wandler digitalisiert und so eine Folge binärer digitaler Eingangswerte des Reflexionssignals erzeugt wird, wobei
a) die Eingangswerte in einer binären Zahlendarstellung in Festkommaformat vorliegen, bei welcher der Betrag der Bitwertigkeiten von einem höchstsignifikanten Bit (MSB) zu einem niedersignifikantesten Bit (LSB) hin jeweils mit dem Faktor 1/2 abnimmt, nur die Bitwerte 0 und 1 vorkommen und es gegebenenfalls ein zusätzliches Vorzeichenbit (VZB) gibt,
b) und die Medianfilterung von jeweils K aufeinanderfolgenden Eingangswerten erfolgt, in dem
c) für die einzelnen Bits beginnend mit dem Vorzeichenbit (VZB), falls es ein solches gibt, oder ansonsten mit dem höchstsignifikanten Bit (MSB) nacheinander bzgl. betragsmäßig absteigender Bitwertigkeit bis zum niedersignifikantesten Bit (LSB)
d) jeweils geprüft wird, ob über alle K Eingangswerte gesehen beim aktuell betrachteten Bit als Bitwert mehr Einsen oder Nullen auftreten,
e) wobei der häufiger auftretende Bitwert dann den Bitwert des aktuell betrachteten Bit des Median darstellt,
f) und für diejenigen Eingangswerte, bei welchen der Bitwert des aktuell betrachteten Bits nicht dem häufiger auftretenden Bitwert entspricht, für alle bezüglich der Reihenfolge nach c) nachfolgenden Bits:
- der mit diesen Bits darstellbare minimale Wert verwendet wird, wenn bezüglich der durch das aktuell betrachtete und die nachfolgenden Bits dargestellten Werte der jeweilige Eingangswert nicht über dem Median liegt; bei Zahlendarstellungen mit Vorzeichenbit (VZB) ist, falls das aktuell betrachtete Bit nicht das Vorzeichenbit (VZB) ist, wobei für die durch das aktuell betrachtete und die nachfolgenden Bits dargestellten Werte das Vorzeichen des Median in die Bitwertigkeiten einzurechnen,
- der mit diesen Bits darstellbare maximale Wert verwendet wird, wenn bezüglich der durch das aktuell betrachtete und die nachfolgenden Bits dargestellten Werte der jeweilige Eingangswert nicht unter dem Median liegt; bei Zahlendarstellungen mit Vorzeichenbit (VZB) ist, falls das aktuell betrachtete Bit nicht das Vorzeichenbit (VZB) ist, wobei für die durch das aktuell betrachtete und die nachfolgenden Bits dargestellten Werte das Vorzeichen des Median in die Bitwertigkeiten einzurechnen.

11. Verfahren nach Anspruch 1, wobei das nichtlineare digitale Filter die folgenden Schritte durchführt:
a) sukzessive wird zu jedem Abtastwert aus den ihm vorausgehenden Abtastwerten durch Extrapolation ein Schätzwert bestimmt,
b) der betrachtete Abtastwert wird mit seinem Schätzwert verglichen,
c) weicht der betrachtete Abtastwert von seinem Schätzwert um mehr als eine vorgegebene Schwelle ab, so wird er als transient gestört erkannt und durch seinen Schätzwert ersetzt.

12. Verfahren nach Anspruch 1, wobei aus dem empfangenen Reflexionssignal ein komplexes Signal mit einem 1-Anteil und einem Q-Anteil erzeugt und jeweils für einen Abtastwert aus dem 1- und Q-Anteil die Leistung ermittelt und mit einem über mehrere zurückliegende Abtastwerte gemittelten Leistungswert verglichen und bei Abweichung der Leistung über einen vorgegebenen Schwellwert der aktuelle Abtastwert als transient gestört erkannt und durch einen aus den vorhergehenden Abtastwerten extrapolierten Wert ersetzt wird.

13. Optisches System zur Objekterfassung, bei dem Lichtimpulse, vorzugsweise im Infrarot-Wellenlängenbereich ausgesendet werden, mit einem nichtlinearen digitalen Filter gegen transiente Störungen zur Durchführung des Verfahrens nach einem der vorangehenden Ansprüche.

14. Radarsystem zur Objekterfassung mit einem nichtlinearen digitalen Filter gegen transiente Störungen zur Durchführung des Verfahrens nach einem der vorangehenden Ansprüche 1 bis 12.

15. Ultraschallsystem zur Objekterfassung mit einem nichtlinearen digitalen Filter gegen transiente Störungen zur Durchführung des Verfahrens nach einem der vorangehenden Ansprüche 1 bis 12.

## Claims

1. A method for suppressing disturbances in systems for detecting objects in a target area, in which:
a) a sequence of pulses (s(t)) is transmitted into the target area by at least one transmitter (ANT0, ANT1, ANT2) and the reflection signals (e(t)) of the pulses are detected by at least one receiver within several time slots, whereby the time slots are in each case oriented with respect to the time slot of the transmission of the individual pulses and in each case represent a distance gate, whereby
b) the time distance (T_{pw}(n)=tₚ(n+1)-tₚ(n)) between the individual pulses (tₚ(n+1),tₚ(n)) is randomly coded according to the pseudo-noise-principle within predefined limits and the time slots are correspondingly adapted
c) and scanning, digitisation, and optionally digital pre-processing and subsequently digital filtering of the received reflection signals in the individual distance gates occurs, whereby a non-linear digital filter for suppressing transient disturbances is used for the filtering.

2. The method as claimed in Claim 1, whereby a median filter is used for the non-linear digital filtering, in which the median is determined in each case from an uneven number of successive scanning values of a reflection signal detected inside a distance gate.

3. The method as claimed in Claim 2, whereby a median filter of a length between 3 to 9 is used.

4. The method as claimed in Claim 2 or 3, whereby a multi-stage median filter is used.

5. The method as claimed in any one of Claims 2 to 4, whereby a dual-stage median filter with a length 5 is used in each case.

6. The method as claimed in any one of Claims 2 to 5, whereby a sliding median filter with overlapping slots of the input values is used.

7. The method as claimed in any one of the preceding claims, whereby overkeying occurs within each distance gate.

8. The method as claimed in any one of the preceding claims, whereby spectral analysis with upstream decimation filtering of the median-filtered reflection signal occurs.

9. The method as claimed in any one of the preceding claims, whereby performance analysis of the median-filtered reflection signal occurs.

10. The method as claimed in any one of the preceding claims, **characterised in that** the reflection signal is detected and scanned, digitised in an analog-digital converter and a sequence of binary digital input values of the reflection signal is thus generated, whereby
a) the input values are in a binary numerical representation in fixed-point format, in which the sum of bit significances declines from a most significant bit (MSB) to a least significant bit (LSB) in each case with the factor 1/2, only the bit values 0 and 1 occur and there is optionally an additional sign bit (SB),
b) and the median filtering of in each case K successive input values occurs, by,
c) for the individual bits beginning with the sign bit (SB), should there be one, or otherwise with the most significant bit (MSB) successively with respect to descending bit significance according to amount to the least significant bit (LSB),
d) checking in each case as to whether there are more ones or zeroes occurring across all K input values with the currently considered bit as bit value,
e) whereby the more frequently occurring bit value then represents the bit value of the currently considered bit of the median,
f) and for those input values, in which the bit value of the currently considered bit does not correspond to the more frequently occurring bit value, for all subsequent bits with respect to the sequence according to c):
- the minimal value representable with these bits is used, if the respective input value is not above the median with respect to the values represented by the currently considered and the subsequent bits; in the case of numerical representations with sign bit (SB), if the currently considered bit is not the sign bit (SB), the sign of the median is to be included in the bit significances for the values represented by the currently considered and the subsequent bits,
- the maximal value representable with these bits is used, if the respective input value is not below the median with respect to the values represented by the currently considered and the subsequent bits; in the case of numerical representations with sign bit (SB), if the currently considered bit is not the sign bit (SB), the sign of the median is to be included in the bit significances for the values represented by the currently considered and the subsequent bits.

11. The method as claimed in Claim 1, whereby the non-linear digital filter performs the following steps:
a) an estimated value is determined successively via extrapolation for each scanned value from the scanned values preceding it,
b) the resulting scanned value is compared to its estimated value,
c) if the resulting scanned value deviates from its estimated value by more than a preset threshold, it is recognised disturbed as transient and is substituted by its estimated value.

12. The method as claimed in Claim 1, whereby a complex signal with a I fraction and a Q fraction is generated from the received reflection signal and the output is in each case determined for a scanned value from the I and Q fraction and compared to a performance value determined by several downstream scanned values and if the output deviated over a preset threshold value the current scanned value is recognised disturbed as transient and is substituted by a value extrapolated from the preceding scanned values.

13. An optical system for detecting objects, in which light pulses are transmitted preferably in the infrared wavelength range, with a non-linear digital filter against transient disturbances for carrying out the method as claimed in any one of the preceding claims.

14. A radar system for detecting objects with a non-linear digital filter against transient disturbances for carrying out the method as claimed in any one of the preceding Claims 1 to 12.

15. An ultrasound system for detecting objects with a non-linear digital filter against transient disturbances for carrying out the method as claimed in any one of the preceding Claims 1 to 12.

## Revendications

1. Procédé pour la suppression de parasites sur des systèmes pour la détection d'objets dans une zone cible, avec lequel :
a) une suite d'impulsions (s(t)) est émise dans la zone cible avec au moins un émetteur (ANT0, ANT1, ANT2) et les signaux réfléchis (e(t)) des impulsions sont captés dans plusieurs fenêtres de temps avec au moins un récepteur, les fenêtres de temps étant respectivement dirigées relativement à l'instant de l'émission des différentes impulsions et représentant ainsi respectivement une porte de distance,
b) l'écart temporel (T_{PW}(n)=tₚ(n+1)-tₚ(n)) entre les différentes impulsions (tₚ(n+1),tₚ(n)) étant codé stochastiquement d'après le principe du pseudo-bruit dans des limites spécifiées et les fenêtres temporelles étant ajustées de façon correspondante
c) et un échantillonnage, une numérisation, le cas échéant un prétraitement numérique et ensuite un filtrage numérique du signal réfléchi reçu étant effectués dans les différentes portes de distance, un filtre numérique non linéaire étant employé pour le filtrage, pour la suppression de parasites transitoires.

2. Procédé selon la revendication 1, un filtre médian étant employé pour le filtrage numérique non linéaire, pour lequel la médiane est déterminée à partir respectivement d'un nombre impair de valeurs d'échantillonnage successives d'un signal réfléchi capté au sein d'une porte de distance

3. Procédé selon la revendication 2, un filtre médian de longueur 3 à 9 étant utilisés.

4. Procédé selon la revendication 2 ou 3, un filtre médian multi-étages étant utilisé.

5. Procédé selon l'une des revendications 2 à 4, un filtre médian à deux étages respectivement de longueur 5 étant utilisé.

6. Procédé selon l'une des revendications 2 à 5, un filtre médian coulissant avec des fenêtres des valeurs d'entrée se chevauchant étant utilisé.

7. Procédé selon l'une des revendications précédentes, un suréchantillonnage ayant lieu dans chaque porte de distance.

8. Procédé selon l'une des revendications précédentes, une analyse spectrale avec filtrage de décimation en amont du signal réfléchi filtré par filtre médian ayant lieu.

9. Procédé selon l'une des revendications précédentes, une analyse de performance du signal réfléchi filtré par filtre médian ayant lieu.

10. Procédé selon l'une des revendications précédentes, **caractérisé en ce que** le signal réfléchi est capté et échantillonné, numérisé dans un convertisseur analogique-numérique et qu'ainsi une suite de valeurs d'entrée numériques binaires du signal réfléchi est générée,
a) les valeurs d'entrée étant données en notation binaire en format à virgule fixe, pour laquelle la valeur des poids de bit décroît d'un bit de poids fort (MSB) à un bit de poids faible (LSB), respectivement avec le facteur ½, seules les valeurs de bit 0 et 1 apparaissent et, le cas échéant, il existe un bit de signe supplémentaire (VZB),
b) et le filtrage médian de respectivement K valeurs d'entrée successives ayant lieu, dans lequel
c) pour les différents bits commençant avec le bit de signe (VZB), s'il y a un tel bit, ou sinon avec le bit de poids fort (MSB), l'un après l'autre relativement au poids de bit décroissant selon la grandeur jusqu'au bit de poids faible (LSB),
d) on vérifie respectivement si, comme valeur de bit, plus d'uns ou de zéros apparaissent pour le bit considéré actuellement, pour l'ensemble des K valeurs d'entrée,
e) la valeur de bit apparaissant le plus souvent représentant alors la valeur de bit du bit de médiane considéré actuellement,
f) et pour les valeurs d'entrée pour lesquelles la valeur de bit du bit considéré actuellement ne correspond pas à la valeur de bit apparaissant le plus souvent, pour tous les bits suivants relativement à l'ordre selon c) :
- la valeur minimale représentable avec ces bits étant employée lorsque la valeur d'entrée respective ne se trouve pas au-dessus de la médiane relativement aux valeurs représentées par le bit considéré actuellement et par les bits suivants ; pour des notations avec bit de signe (VZB), au cas où le bit considéré actuellement n'est pas le bit de signe (VZB), le signe de la médiane devant être inclus dans les poids de bit pour la valeur représentée par le bit considéré actuellement et par les bits suivants,
- la valeur maximale représentable avec ces bits étant employée lorsque la valeur d'entrée respective ne se trouve pas en dessous de la médiane, relativement aux valeurs représentées par le bit considéré actuellement et par les bits suivants ; pour des notations avec bit de signe (VZB), au cas où le bit considéré actuellement n'est pas le bit de signe (VZB), le signe de la médiane devant être inclus dans les poids de bit pour les valeurs représentées par le bit considéré actuellement et par les bits suivants,

11. Procédé selon la revendication 1, le filtre numérique non linéaire exécutant les étapes suivantes :
a) une valeur estimée est déterminée successivement par extrapolation pour chaque valeur d'échantillonnage, à partir des valeurs d'échantillonnage la précédant,
b) la valeur d'échantillonnage considérée est comparée avec sa valeur estimée,
c) si la différence entre la valeur d'échantillonnage considérée et sa valeur estimée dépasse un seuil spécifié, elle est alors reconnue comme brouillée transitoirement et remplacée par sa valeur estimée.

12. Procédé selon la revendication 1, un signal complexe avec une composante l et une composante Q étant généré à partir du signal de réflexion reçu, et la puissance étant déterminée respectivement pour une valeur d'échantillonnage à partir de la composante l et de la composante Q et comparée avec une valeur de puissance moyennée à partir de plusieurs valeurs d'échantillonnage précédentes et, lors d'un écart supérieur à une valeur de seuil spécifiée de la puissance, la valeur d'échantillonnage actuelle étant reconnue comme brouillée de façon transitoire et pouvant être remplacée par une valeur extrapolée à partir des valeurs d'échantillonnage précédentes.

13. Système optique pour la détection d'objets, sur lequel des impulsions lumineuses, de préférence dans la gamme de longueurs d'onde infrarouges sont émises, avec un filtre numérique non linéaire contre les parasites transitoires pour l'exécution du procédé selon l'une des revendications précédentes.

14. Système radar pour la détection d'objets avec un filtre numérique non linéaire contre les parasites transitoires pour l'exécution du procédé selon l'une des revendications précédentes 1 à 12.

15. Système à ultrasons pour la détection d'objets avec un filtre numérique non linéaire contre les parasites transitoires pour l'exécution du procédé selon l'une des revendications précédentes 1 à 12.
